# EUROPEAN PATENT SPECIFICATION

(11) **EP 0 625 712 B1**
(45) Date of publication and mention of the grant of the patent: **24.09.1997**
(21) Application number: 94111856.4
(22) Date of filing: 10.07.1990
(51) Int. Cl.: G01R 33/035, G01R 33/022

(54) **A pick-up coil assembly for multi-channel SQUID magnetic gradiometer**
Aufnehmerspulenanordnung für Mehrkanal-SQUID-Magnetfeld-Gradiometer
Ensemble de bobines de captage pour une gradomètre magnétique multicanal à SQUID

(30) Priority: 10.07.1989 JP 178858/89; 30.08.1989 JP 223869/89
(43) Date of publication of application: 23.11.1994
(62) Divisional of application: 90307515.8
(73) Proprietor: FUJITSU LIMITED, Kawasaki-shi, Kanagawa 211 (JP)
(72) Inventor: Igarashi, Yutaka, c/o Fujitsu Limited, Kawasaki-shi, Kanagawa 211 (JP); Goto, Takao, c/o Fujitsu Limited, Kawasaki-shi, Kanagawa 211 (JP); Hayashi, Takehiko, c/o Fujitsu Limited, Kawasaki-shi, Kanagawa 211 (JP)
(74) Representative: Stebbing, Timothy Charles

(56) References cited:
- EP-A- 0 130 490
- EP-A- 0 184 670
- EP-A- 0 200 958
- EP-A- 0 313 132
- IEEE TRANSACTIONS ON GEOSCIENCE AND REMOTE SENSING, vol.GE-23, no.4, July 1985, NEW YORK pages 552 - 561 R. HASTINGS ET AL. 'Cryogenic magnetic gradiometers for space applications'

## Description

The present invention relates to a pick-up coil assembly for a magnetic gradiometer using a plurality of superconducting quantum interference devices (SQUID's).

A SQUID is widely used for detecting a weak magnetic field with very high sensitivity. That is, a SQUID can respond to a change in a weak magnetic field based on a quantum interference effect of the magnetic field. Accordingly, a SQUID is mainly utilized for, particularly, a high sensitivity gradiometer having a pick-up coil assembly as a magnetic sensor. A SQUID gradiometer is utilized, for example, in the medical equipment field to measure the weak magnetic field generated by the heart of a human body.

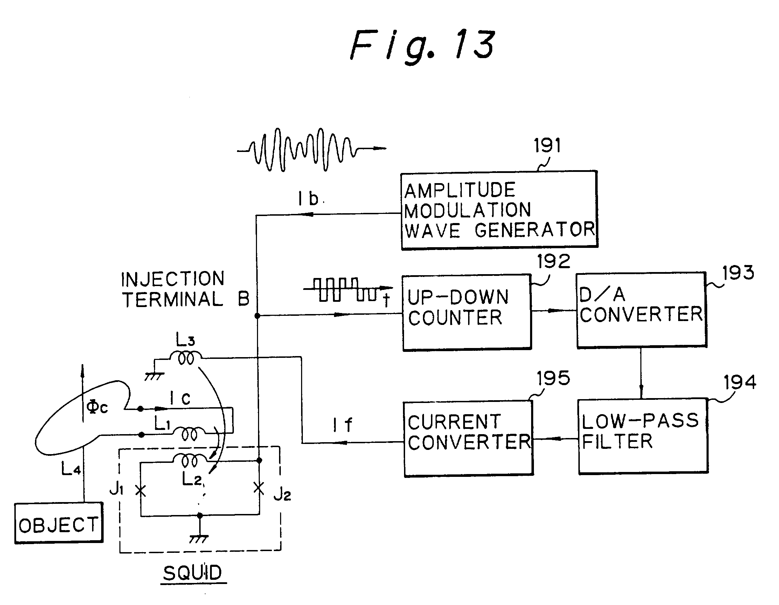

A detecting stage of a digital SQUID magnetometer (see Fig. 13) may be constituted by a superconductive pick-up coil for detecting a weak magnetic field from an object (human body), a superconductive input coil provided in the SQUID and magnetically coupled to the pick-up coil, and a superconductive feedback coil magnetically coupled to these coils. In general, the pick-up coil assembly is constituted by a plurality of coils (multi-channel), each coil corresponding to one channel, since it is necessary to simultaneously detect the magnetic field over a wide area on the object. For example, about 36 individual pick-up coils are necessary for diagnosing the heart.

In this case, since the pick-up coil assembly must detect a very weak magnetic field without dispersion of characteristics among pick-up coils, it is necessary to assemble the pick-up coil assembly with very high precision, particularly structural precision, so as to have high uniformity among coils.

EP-A-0 130 490 discloses a pick-up coil assembly for a multi-channel SQUID gradiometer according to the preamble of each of the accompanying independent claims.

EP-A-0 200 958 discloses a multi-channel second order SQUID gradiometer with pick-up coils arranged in three flat or curved planes.

According to a first aspect of the present invention, there is provided a pick-up coil assembly for a multi-channel SQUID magnetic gradiometer, comprising:
an upper and a lower support plate, and a plurality of pick-up coils and connection pads provided on the support plates, the pick-up coils and the connection pads being formed by a lithography technique; and
superconductive connections for connecting respective pick-up coils of the upper support plate with corresponding pick-up coils of the lower support plate so as to form first order gradiometers;
characterised in that:
each support plate has a centre penetrating hole, and a plurality of positioning holes and of connecting holes arranged in an array configuration;
a support bar is provided for fixedly mounting each support plate through its centre penetrating hole;
a plurality of coil base plates are provided on each support plate, each coil base plate having a positioning hole coinciding with a positioning hole in the support plate;
a respective one of said pick-up coil and connection pads are formed on each coil base plate;
and in that said superconductive connections are superconductive wires which pass through the connecting holes of at least one of the support plates.

According to a second aspect of the present invention, there is provided a pick-up coil assembly for a multi-channel SQUID magnetic gradiometer, comprising:
an upper and a lower support plate;
a plurality of pick-up coils arranged on each support plate in an array configuration, each of the pick-up coils being formed by a lithography technique on the support plate; and
superconductive connections for connecting respective pick-up coils of the upper support plate with corresponding pick-up coils of the lower support plate so as to form first order gradiometers;
characterised in that
each support plate has a centre penetrating hole;
a support bar is provided for fixedly mounting each support plate through its centre penetrating hole;
and in that said superconductive connections are superconductive wires which pass through connecting holes provided in at least one of the support plates.

An embodiment of the present invention can provide a pick-up coil assembly for a multi-channel SQUID gradiometer, having precision and high uniformity of characteristics detected among coils.

Two pairs of support plates can be provided so as to form a second order gradiometer by connecting the pick-up coils of all four support plates using the superconductive wires.

Reference will now be made, by way of example, to the accompanying drawings, in which:
Fig. 1 shows one example of a pick-up coil assembly for a multi-channel SQUID gradiometer;
Fig. 2 shows another example of a pick-up coil assembly for a multi-channel SQUID gradiometer;
Fig. 3 shows a basic form of a first order gradiometer;
Fig. 4 shows a basic form of a second order gradiometer;
Figs. 5A to 5G are views for explaining the manufacturing process of a pick-up coil using the lithography technique, applicable to the present invention;
Fig. 6 is a schematic view of a pick-up coil assembly embodying the present invention;
Fig. 7 is a detailed view of a part of the assembly shown in Fig. 6;
Figs. 8A and 8B are views for explaining the construction of a second order gradiometer embodying the present invention;
Fig. 9 shows an alternative form of the part shown in Fig. 7;
Fig. 10 shows a further alternative form of a supporting structure of the Fig. 6 assembly;
Fig. 11 is a schematic view of another pick-up coil assembly embodying the present invention;
Fig. 12 is a schematic side elevational view of a support bar of an assembly embodying the present invention; and
Fig. 13 is a schematic block diagram of a digital SQUID control system for use in a digital SQUID gradiometer.

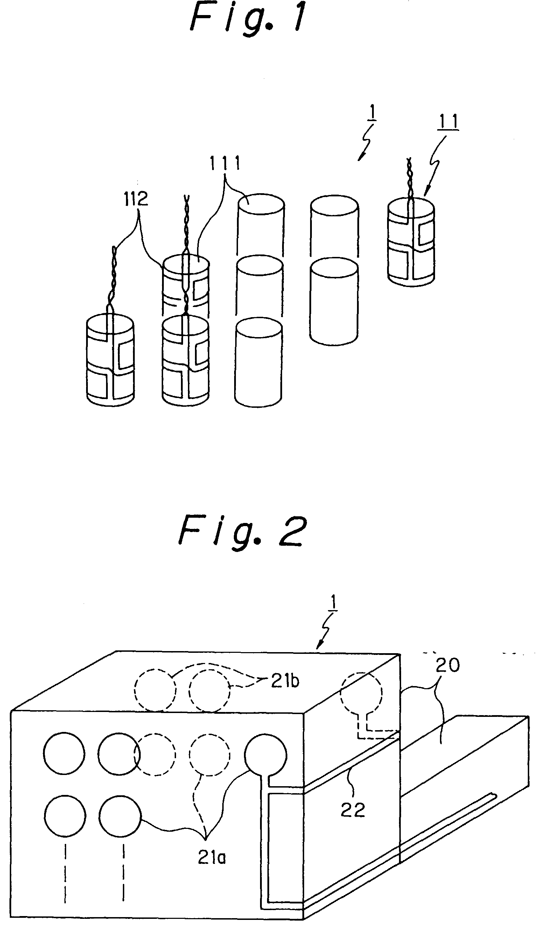

Figure 1 shows one type of pick-up coil assembly. This type of pick-up coil assembly 1 is constituted by a plurality of pick-up coils 11. Each of pick-up coils 11 has a coil bobbin 111 and a superconductive wire 112. The coil bobbin 111 is made of a non-magnetized material.

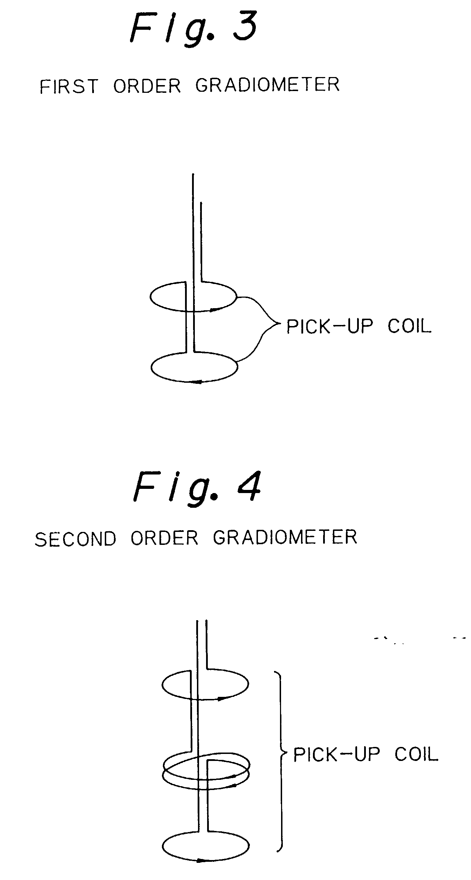

In this case, the superconductive wire 112 is manually wound on the coil bobbin 111 along with a groove (not shown) to form the first or second order gradiometer shown in Fig. 3 or Fig. 4.

In a manufacturing process of the above pick-up coil assembly, however, it is very difficult to obtain high uniformity among coils so that this winding work wastes much time. Further, since the magnetic field from the human body is very weak, it is necessary to manufacture the pick-up coil with very high structural precision for sufficiently eliminating environmental magnetic noise. Since the intensity of the magnetic field from the heart is on the order of about 10⁻¹⁰ Tesla, it is necessary to ensure the structural precision in line with the above intensity. However, limitation of structural precision of this type is about 10⁻³ so that it is necessary to measure a weak magnetic field in a magnetically shielded room which can completely eliminate environmental magnetic noise.

Figure 2 is another example of a pick-up coil assembly for a multi-channel SQUID magnetometer. This type of the pick-up coil assembly is disclosed in Japanese Unexamined Patent Publication (Kokai) No. 59-133474 (corresponding to U.S. Serial No. 4,749,946).

This type of the pick-up coil assembly 1 is constituted by a support body 20 and a plurality of pick-up coils 21a and 21b provided on the support body 20. In this case, the pick-up coils 21b are provided on opposite surfaces of the pick-up coil 21a, and connected thereto by a connection line 22.

In this case, each of pick-up coils 21a and 21b is formed by a lithography technique which is widely utilized in the field of integrated circuit (IC) manufacturing.

There are, however, some problems in the manufacturing process using the lithography technique as explained in detail below.

First, in general, in the case of the diagnosis of the heart, it is necessary to provide 36 individual pick-up coils to detect the weak magnetic field from the heart. In this case, the 36 coils are arranged in a matrix of 6 columns x 6 rows. Accordingly, since the diameter of one pick-up coil is about 2 to 3 cm, the size of one surface of the support body 20 becomes 15 cm x 15 cm to provide the pick-up coil assembly. However, it is difficult to provide a large lithography device which can print such large numbers of lithography patterns (i.e., a plurality of pick-up coils 21a and 21b) on both surfaces of the support body 20.

Second, it is difficult to provide the lithography patterns connecting the pick-up coils 21a and 21b (i.e., connection lines 22) because very fine adjustment of the position is necessary for printing the above patterns in an additional manufacturing process.

Third, as explained above, at least the surface area of 15 cm x 15 cm is necessary for diagnosing the heart. However, it is very difficult to provide uniformity among all of the pick-up coils, particularly, if the pickup coils are printed on four corners.

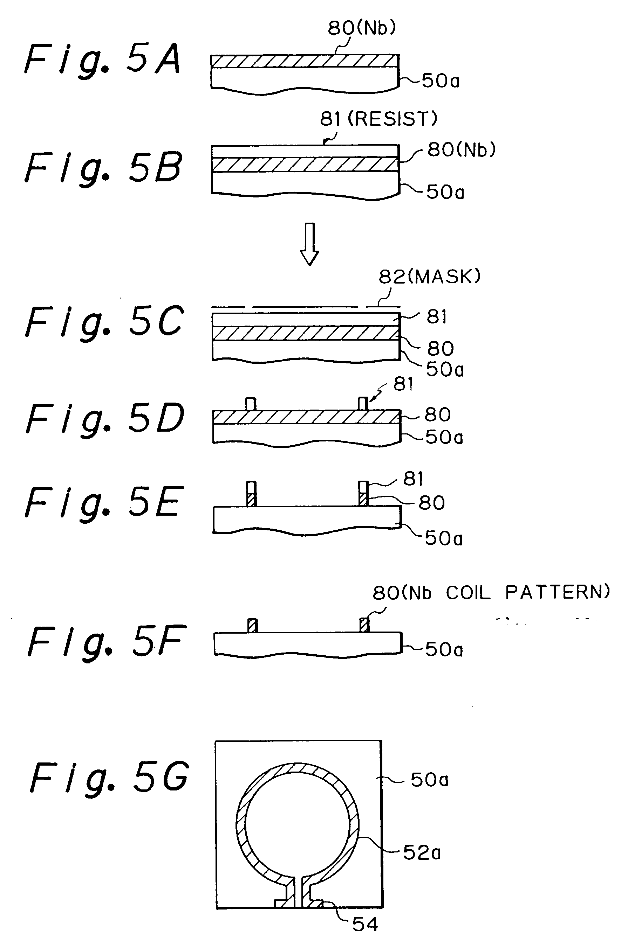

Figures 5A to 5G are views for explaining a manufacturing process of a pick-up coil using the lithography technique. In Figs. 5A to 5G, 80 denotes a niobium (Nb) thin layer, 81 a resist layer, and 82 a mask film.

In Fig. 5A, the niobium thin layer 80 is formed on a glass (or silicon: Si) body 50a by using a sputtering method.

In Fig. 5B, the resist material is spread on the niobium thin layer 80, the spread resist material is baked to be hardened by using a pre-bake method, and the resist layer 81 is formed on the glass body 50a.

In Fig. 5C, the mask film 82 having the pattern of the pick-up coil is put on the resist layer 81.

In Fig. 5D, after exposing, developing and heating are performed by using a post-bake method so that the resist layer 81 remains along with the pattern of the pick-up coil 52a.

In Fig. 5E, the niobium thin layer 80 which is not covered by the resist layer 81 is eliminated by using a dry-etching method.

In Fig. 5F, the resist layer 81 is eliminated by a solvent, for example, an acetone solvent, and only the niobium thin layer 80 is formed on the glass body 50a.

In Fig. 5G, finally, the pick-up coil 52a having the desired configuration is formed on the glass body 50a.

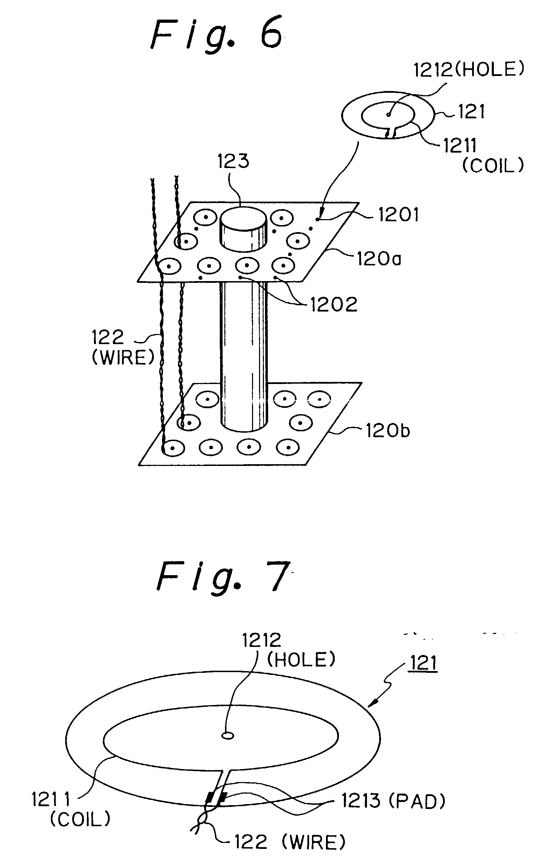

Figure 6 is a schematic view of a pick-up coil assembly embodying the present invention. In Fig. 6, 120a and 120b denote support plates. Each support plate 120a and 120b has a plurality of holes 1201 and 1202. The holes 1201 are used for positioning, and the holes 1202 are used for connection.

121 denotes a coil base plate having a pick-up coil 1211 and a small hole 1212. A plurality of the coil base plates 121 are arranged on the support plates 120a and 120b in a matrix form. In the arrangement of the coil base plate 121, the small hole 1212 coincides with the hole 1201 on the support plates 120a and 120b.

122 denotes a superconductive wire. As shown, each wire 122 is a twisted wire. The upper pick-up coil 1211 is connected to the corresponding pick-up coil on the support plate 120b by using the superconductive wire 122 through the hole 1202.

123 denotes a support bar for fixedly supporting the support plates 120a and 120b. The structure of each part is explained in detail hereinafter.

Figure 7 is a detailed view of the coil base plate 121 shown in Fig. 6. As explained above, the coil base plate 121 has the pick-up coil 1211 formed by the lithography technique and the small hole 1212. Further, the coil base plate 121 has pads 1213 connected to the pick-up coil 1211. The pads 1213 are simultaneously formed by the lithography technique and connected to the twisted wire 122. The small hole 1212 is provided on the centre of the coil base plate 121 for obtaining precise arrangement on the support plates 120a and 120b.

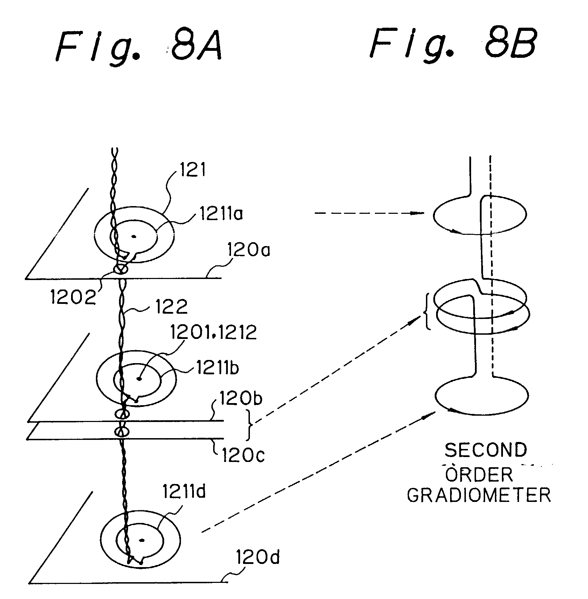

Figures 8A and 8B are views for explaining a second order gradiometer embodying the invention. To form the second order gradiometer, four sets of the coil base plates 121a to 121d are provided on each of four support plates 120a to 120d. Four pick-up coils 1211a to 1211d are cross-connected by the twisted superconductive wire 122 through each hole 1202 on each support plate 120a to 120c so as to form the second order gradiometer as shown in Fig. 8B.

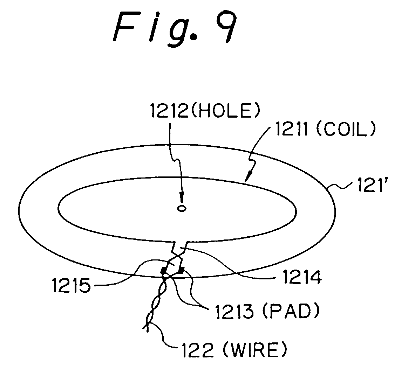

Figure 9 is another example of a coil base plate for use in an embodiment of the invention. In Fig. 9, the coil base plate 121' is of the same basic structure as that shown in Fig. 7. However, as shown in the drawing, the end of the loop is cross-connected to the pad 1213 so as to form spaces 1214 and 1215. In this case, the spaces 1214 and 1215 have the same size. Accordingly, it is possible to prevent magnetic noise by this cross-connection.

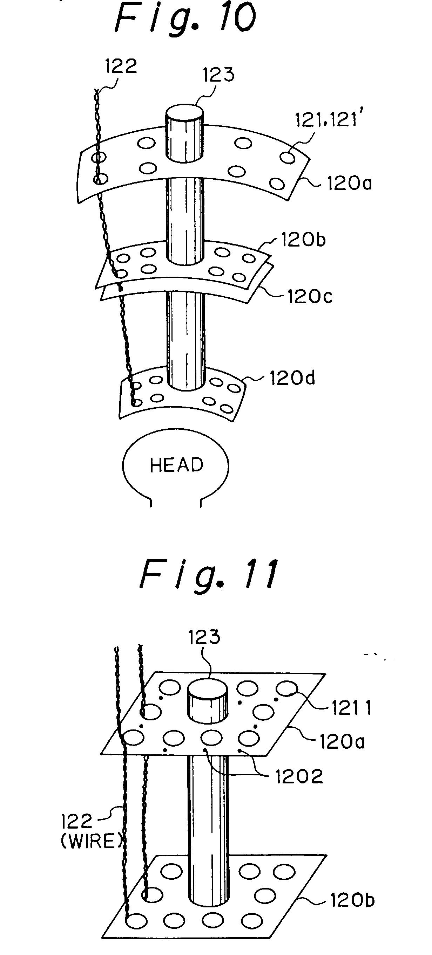

Figure 10 is another example of the support plate. As shown in the drawing, each of support plates 120a to 120d are curved. In this case, the support plate is previously curved so as to fit against the surface of an object, for example, the head of a human body. After this process, a plurality of the coil base plates 121 are provided on the support plates 120a to 120d.

Figure 11 is a schematic view of another pick-up coil assembly embodying the present invention. In Fig.ll, 120a and 120b denote support plates. A plurality of pick-up coils 1211 are directly formed by the same lithography technique as shown by Figs. 5A to 5G on the support plate 120a and 120b. In this case, the coil base plate 121 is not necessary, and the small hole 1201 is also not necessary on the support plates 120a and 120b. Only the support plates with the coils, support bar 123 and superconductive twisted wires 122 are needed in this pick-up coil assembly.

In this case, the structural precision of this type can be ensured in spite of the large area of the support plate because the support plate 120 is constituted by the glass plate (not the glass block as shown in Fig.2).

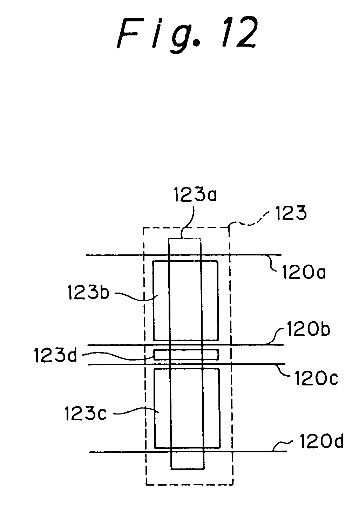

Figure 12 is a view for explaining a detail structure of the support bar. The support bar 123 is constituted by a centre bar 123a, two supplementary bars 123b and 123c, and a spacer 123d. It is possible to ensure the flatness among the support plates 120a to 120d.

Figure 13 is a schematic block diagram of a digital SQUID control system used for the digital SQUID gradiometer. In Fig 13, L₄ denotes a pick-up coil. The SQUID is constituted by two Josephson devices and a superconductive coil L₂. Further, L₁ denotes a superconductive input coil, and L₃ denotes a superconductive feedback coil. Reference number 191 denotes an amplitude modulation wave generator, 192 an up-down counter, 193 a digital-to-analog converter, 194 a low-pass filter and 195 a current converter.

A pick-up coil assembly embodying the present invention can be applied to the pick-up coil L₄.

Briefly, the pick-up coil L₄ detects a weak magnetic field Φ_{c} irradiated from the object to be measured. Accordingly, the current flows in input coil L₁ in response to change of the magnetic field Φ_{c}. The coil L₂ of the SQUID is arranged in the vicinity of the input coil L₁ so as to obtain magnetic coupling with each other. Further, an alternating bias current I_{b} generated from the generator 191 flows in the SQUID through an injection terminal B. The bias current I_{b} is superimposed on the current flowing in the SQUID. Reference I_{f} denotes a feedback current flowing from the converter 195 to the coil L₃.

A patent application for the digital SQUID control system discussed above has already been filed in the United States on March 27, 1990, in the names of the present inventors and has been published as US-A-5 045 788.

As explained above, a pick-up coil assembly embodying the present invention comprises a plurality of pick-up coils arranged in an array configuration (for example, matrix) for enabling multi-channel measurement of a magnetic field. Such a coil assembly may be advantageously utilized in a digital SQUID gradiometer.

## Claims

1. A pick-up coil assembly for a multi-channel SQUID magnetic gradiometer, comprising:
an upper and a lower support plate (120a, 120b), and a plurality of pick-up coils (1211) and connection pads (1213) provided on the support plates, the pick-up coils and the connection pads being formed by a lithography technique; and
superconductive connections for connecting respective pick-up coils (1211) of the upper support plate (120a) with corresponding pick-up coils of the lower support plate (120b) so as to form first order gradiometers;
characterised in that:
each support plate (120a, 120b) has a centre penetrating hole, and a plurality of positioning holes (1201) and of connecting holes (1202) arranged in an array configuration;
a support bar (123) is provided for fixedly mounting each support plate (120a, 120b) through its centre penetrating hole;
a plurality of coil base plates (121) are provided on each support plate (120a, 120b), each coil base plate having a positioning hole (1212) coinciding with a positioning hole (1201) in the support plate (120a, 120b);
a respective one of said pick-up coils (1211) and connection pads (1213) are formed on each coil base plate (121);
and in that said superconductive connections are superconductive wires (122) which pass through the connecting holes (1202) of at least one of the support plates.

2. A pick-up coil assembly as claimed in claim 1, wherein two pairs of the support plates (120a, 120b; 120c, 120d) are provided so as to form a second order gradiometer by connecting the pick-up coils (1211) of the four support plates (120a, 120b; 120c, 120d) using said superconductive wires (122).

3. A pick-up coil assembly for a multi-channel SQUID magnetic gradiometer, comprising:
an upper and a lower support plate (120a, 120b);
a plurality of pick-up coils (1211) arranged on each support plate (120a, 120b) in an array configuration, each of the pick-up coils (1211) being formed by a lithography technique on the support plate; and
superconductive connections for connecting respective pick-up coils (1211) of the upper support plate (120a) with corresponding pick-up coils of the lower support plate (120b) so as to form first order gradiometers ;
characterised in that
each support plate (120a, 120b) has a centre penetrating hole;
a support bar (123) is provided for fixedly mounting each support plate (120a, 120b) through its centre penetrating hole;
and in that said superconductive connections are superconductive wires (122) which pass through connecting holes (1202) provided in at least one of the support plates (120a, 120b).

4. A pick-up coil assembly as claimed in claim 3, wherein two pairs of the support plates (120a, 120b; 120c, 120d) are provided so as to form a second order gradiometer by connecting the pick-up coils (1211) of the four support plates (120a, 120b; 120c, 120d) using said superconductive wires (122).

## Patentansprüche

1. Aufnahmespulenbaugruppe für einen magnetischen Mehrkanal-SQUID-Gradmesser, mit:
einer oberen und einer unteren Stützplatte (120a, 120b), und einer Vielzahl von Aufnahmespulen (1211) und Verbindungsinseln (1213), die auf den Stützplatten vorgesehen sind, welche Aufnahmespulen und welche Verbindungsinseln durch ein Lithografieverfahren gebildet sind; und
supraleitfähigen Verbindungen zum Verbinden jeweiliger Aufnahmespulen (1211) der oberen Stützplatte (120a) mit entsprechenden Aufnahmespulen der unteren Stützplatte (120b), um Gradmesser erster Ordnung zu bilden;
dadurch gekennzeichnet, daß:
jede Stützplatte (120a, 120b) ein zentrales Durchgangsloch hat, und eine Vielzahl von Positionierungslöchern (1201) und von Verbindungslöchern (1202), die in einer Arraykonfiguration angeordnet sind;
eine Stützschiene (123) zum festen Montieren jeder Stützplatte (120a, 120b) durch ihr zentrales Durchgangsloch vorgesehen ist;
eine Vielzahl von Spulenbasisplatten (121) auf jeder Stützplatte (120a, 120b) vorgesehen ist, wobei jede Spulenbasisplatte ein Positionierungsloch (1212) hat, das mit einem Positionierungsloch (1201) in der Stützplatte (120a, 120b) koinzidiert;
eine jeweilige der Aufnahmespulen (1211) und Verbindungsinseln (1213) auf jeder Spulenbasisplatte (121) gebildet sind;
und daß die supraleitfähigen Verbindungen supraleitfähige Drähte (122) sind, die durch die Verbindungslöcher (1202) von wenigstens einer der Stützplatten verlaufen.

2. Aufnahmespulenbaugruppe nach Anspruch 1, bei der zwei Paare der Stützplatten (120a, 120b; 120c, 120d) vorgesehen sind, um einen Gradmesser zweiter Ordnung zu bilden, indem die Aufnahmespulen (1211) der vier Stützplatten (120a, 120b; 120c, 120d) unter Verwendung der supraleitfähigen Drähte (122) verbunden werden.

3. Aufnahmespulenbaugruppe für einen magnetischen Mehrkanal-SQUID-Gradmesser, mit:
einer oberen und einer unteren Stützplatte (120a, 120b);
einer Vielzahl von Aufnahmespulen (1211), die auf jeder Stützplatte (120a, 120b) in einer Arraykonfiguration angeordnet sind, wobei jede der Aufnahmespulen (1211) durch ein Lithografieverfahren auf der Stützplatte gebildet ist; und
supraleitfähigen Verbindungen zum Verbinden jeweiliger Aufnahmespulen (1211) der oberen Stützplatte (120a) mit entsprechenden Aufnahmespulen der unteren Stützplatte (120b), um Gradmesser erster Ordnung zu bilden;
dadurch gekennzeichnet, daß:
jede Stützplatte (120a, 120b) ein zentrales Durchgangsloch hat;
eine Stützschiene (123) zum festen Montieren jeder Stützplatte (120a, 120b) durch ihr zentrales Durchgangsloch vorgesehen ist;
und daß die supraleitfähigen Verbindungen supraleitfähige Drähte (122) sind, die durch Verbindungslöcher (1202) verlaufen, die in wenigstens einer der Stützplatten (120a, 120b) vorgesehen sind.

4. Aufnahmespulenbaugruppe nach Anspruch 3, bei der zwei Paare der Stützplatten (120a, 120b; 120c, 120d) vorgesehen sind, um einen Gradmesser zweiter Ordnung zu bilden, indem die Aufnahmespulen (1211) der vier Stützplatten (120a, 120b; 120c, 120d) unter Verwendung der supraleitfähigen Drähte (122) verbunden werden.

## Revendications

1. Ensemble de bobines de captage pour un gradomètre magnétique multicanaux à SQUID, comprenant:
une plaque de support supérieure, une plaque de support inférieure (120a, 120b) et une pluralité de bobines de captage (1211) et de pastilles de connexion (1213) présentes sur les plaques de support, les bobines de captage et les pastilles de connexion étant formées au moyen d'une technique lithographique; et
des connexions supraconductrices pour connecter les bobines de captage correspondantes (1211) de la plaque de support supérieure (120a) avec les bobines de captage correspondantes de la plaque de support inférieure (120b) de manière à former des gradomètres de premier ordre;
caractérisé en ce que:
chaque plaque de support (120a, 120b) comporte un trou pénétrant central, et une pluralité de trous de positionnement (1201) et de trous de connexion (1202) ménagés sous forme de rangées;
une barre de support (123) est présente pour monter fermement chaque plaque de support (120a, 120b) à travers son trou pénétrant central;
une pluralité de plaques de socle de bobine (121) sont présentes sur chaque plaque de support (120a, 120b), chaque plaque de support de bobine comportant un trou de positionnement (1212) coïncidant avec le trou de positionnement (1201) de la plaque de support (120a, 120b); la bobine correspondante desdites bobines de captage (1211) et les pastilles de connexion (1213) sont formées sur chaque plaque de socle de bobine (121);
et en ce que lesdites connexions supraconductrices sont des fils supraconducteurs (122) qui traversent les trous de connexion (1202) d'au moins l'une des plaques de support.

2. Ensemble de bobines de captage selon la revendication 1, dans lequel deux paires de plaques de support (120a, 120b, 120c, 120d) sont présentes de manière à former un gradomètre de second ordre en connectant les bobines de captage (1211) des quatres plaques de support (120a, 120b, 120c, 120d) en utilisant lesdits fils magnétiques (122).

3. Ensemble de bobines de captage destiné à un gradomètre magnétique multicanaux à SQUID, comprenant:
une plaque de support supérieure et une plaque de support inférieure (120a, 120b);
une pluralité de bobines de captage (1211) disposées sur chaque plaque de support (120a, 120b) sous forme de rangées, chacune des bobines de captage (1211) étant formée au moyen d'une technique lithographique sur la plaque de support; et
des connexions supraconductrices destinées à connecter les bobines de captage correspondantes (1211) de la plaque de support supérieure (120a) avec les bobines de captage correspondantes de la plaque de support inférieure (120b) de manière à former un gradomètre de premier ordre;
caractérisé en ce que
chaque plaque de support (120a, 120b) comporte un trou pénétrant central;
une barre de support (123) est présente pour monter fermement chaque plaque de support (120a, 120b) à travers son trou pénétrant central;
et en ce que lesdites connexions supraconductrices sont des fils supraconducteurs (122) qui traversent les trous de connexion (1202) qui sont présents dans au moins l'une des plaques de support (120a, 120b).

4. Ensemble de bobines de captage selon la revendication 3, dans lequel deux paires de plaques de support (120a, 120b, 120c, 120d) sont présentes de manière à former un gradomètre de second ordre en connectant les bobines de captage (1211) des quatre plaques de support (120a, 120b, 120c, 120d) en utilisant lesdits fils supraconducteurs (122).
